Europäisches Patentamt

European Patent Office

Office européen des brevets

(19)

(11) **EP 0 744 829 B1**

(12) **EUROPEAN PATENT SPECIFICATION**

(45) Date of publication and mention
of the grant of the patent:
**15.01.2003   Bulletin 2003/03**

(51) Int Cl.$^7$: **H03H 1/00**, H03F 3/45

(21) Application number: **95830217.6**

(22) Date of filing: **22.05.1995**

(54) **A high-pass filter, particularly for cancelling out the offset in a chain of amplifiers**

Hochpassfilter, insbesondere für die Offsetunterdrückung in einer Verstärkerkette

Un filtre passe-haut, notamment pour l'élimination du signal offset dans une chaîne d'amplificateurs

(84) Designated Contracting States:
**DE FR GB IT**

(43) Date of publication of application:
**27.11.1996   Bulletin 1996/48**

(73) Proprietor: **STMicroelectronics S.r.l.**
**20041 Agrate Brianza (Milano) (IT)**

(72) Inventors:
• **Tomasini, Luciano**
**I-20052 Monza (Milano) (IT)**
• **Castello, Rinaldo**
**I-20043 Arcore (Milano) (IT)**

• **Bietti, Ivan**
**I-46040 Casalromano (IT)**
• **Clerici, Giancarlo**
**I-20090 Vimodrone (Milano) (IT)**

(74) Representative: **Maggioni, Claudio et al**
**Jacobacci & Partners S.p.A.,**
**Via Senato, 8**
**20121 Milano (IT)**

(56) References cited:
**EP-A- 0 397 250        FR-A- 2 304 216**
**US-A- 4 833 418        US-A- 4 982 155**

## Description

The present invention relates to a high-pass filter as defined in the preamble of claim 1 or claim 2 and known from document US-A-4 982 155, which is particularly suitable for use for cancelling out the offset in a chain of amplifiers.

As is known, in order to produce an amplifier with a very high gain, several amplifiers are connected in cascade so that the overall gain is the product of the gains of the individual stages. It is also known that each stage has an "offset" (the voltage which has to be applied as an input in order to have a zero output voltage) which, although it can be reduced to very low values by suitable structural measures, can never be completely eliminated. A typical value of the offset for a differential operational amplifier with a voltage gain of 1, formed in a bipolar integrated circuit, is between 2 and 3 mV. In a chain of amplifiers of this type, coupled to one another directly, with an overall gain of 40 dB, the overall offset is thus between 200 and 300 mV.

In many applications, particularly those in which the dynamics of the signal to be amplified are low and the supply voltage of the amplifiers is also low as in the case of telephone-band amplifiers, these offset values are not acceptable.

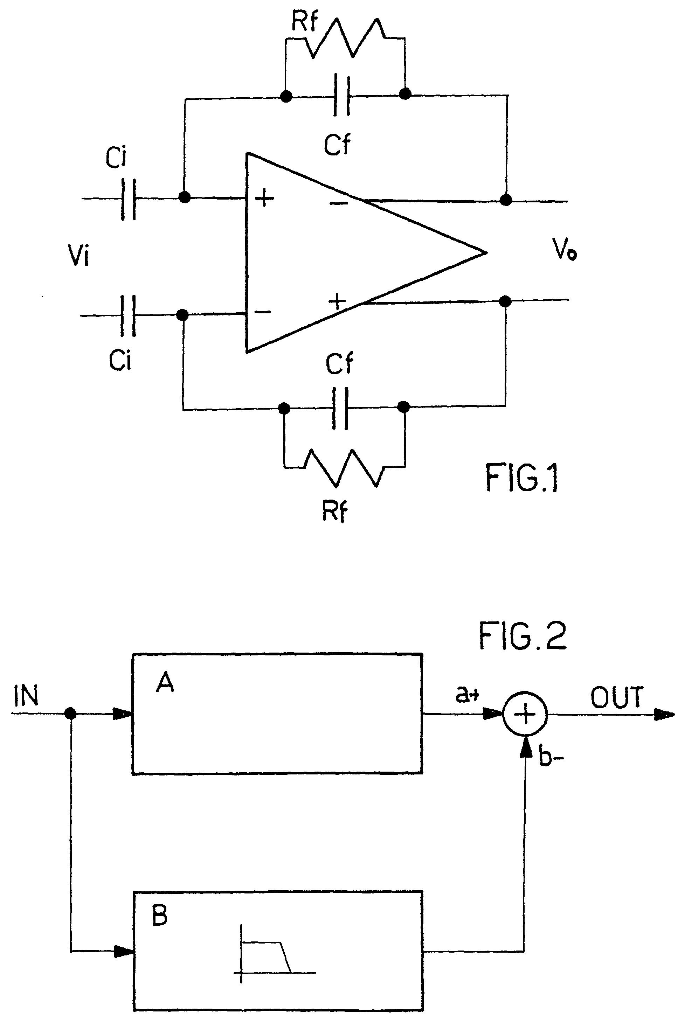

A typical method of eliminating or at least reducing the effect of the offset between two amplifier stages in cascade is that of connecting a high-pass filter, that is, a direct-current decoupler, between them. A known filter is shown, for example, in Figure 1. The filter consists of a differential operational amplifier with feedback from each output by means of a capacitor and a resistor, Rf and Cf, in parallel, and of two capacitors Ci in series with the inputs. The transfer function of the filter, as voltage, is given by:

$$H(\omega) = \frac{Vo}{Vi} = \frac{Ci}{Cf} \; \frac{j\omega}{\frac{1}{RfCf} + j\omega}$$

in which Vo and Vi indicate the output and input voltages, respectively, and in which the capacitance and resistance values are indicated by the same symbols as are used to identify the corresponding components in the drawing.

This function has a single pole for

$$\omega p = \frac{1}{RfCf}$$

and a single zero at a frequency of zero. The filter therefore allows all of the signals with frequencies above the cut-off frequency to pass and blocks any direct-current component present at its input. When this filter is connected between two amplifiers, it therefore completely cancels out the offset due to the stages upstream. The only remaining offset is that due to the filter itself and, typically, is between 2 and 3 mV.

The known filter described above can be used advantageously for cancelling out the offset in a chain of amplifiers. When used in an integrated circuit, however, it takes up a fairly large area, mainly because of the capacitors which form part of it.

The main object of the present invention is to propose a high-pass filter which has functional characteristics similar to those of a known filter of the type described above but which can be used in an integrated circuit with less wastage of area.

This object is achieved by the provision of the high-pass filters according to the invention as claimed in claims 1 and 2.

The invention will be understood better from the following detailed description of an embodiment thereof given by way of non-limiting example with reference to the appended drawings, in which:

Figure 1, which has already been described, is the circuit diagram of a known high-pass filter,

Figure 2 is a block diagram of another known high-pass filter,

Figure 3 is the circuit diagram of a single-ended version of the high-pass filter according to Figure 2,

Figure 4 is the circuit diagram of a differential version of the high-pass filter according to Figure 2,

Figure 4a is the circuit diagram of a high-pass filter according to the invention and

Figure 5 is a circuit diagram similar to that of Figure 4a with a variation.

In Figure 2, the known high-pass filter is shown by a single circuit unit constituted by two branches, indicated A and B, and by an adder. The branch A comprises circuit means for transferring an input signal substantially without modifying its frequency content and the branch B comprises a low-pass filter. At one end, both of the two branches are connected to the input IN of the filter and at the other end the two branches are connected to two inputs, indicated a+ and b-, of the adder. The output of the adder is the output of the filter.

The transfer means of the branch A, the low-pass filter of the branch B and the adder are of dimensions such that the components of the input signal which have frequencies below the cut-off frequency of the low-pass filter are substantially cancelled out at the output of the adder. This occurs on account of the fact that the signals at the inputs a+ and b- of the adder are substantially in phase with one another and have the same amplitude but have opposite signs. Clearly, therefore, signals with frequencies greater than the cut-off frequency pass through the filter unaltered, whilst those of lower frequencies cannot pass through because their algebraic sum is zero. In other words, a high-pass filter is formed by a low-pass filter and an adder.

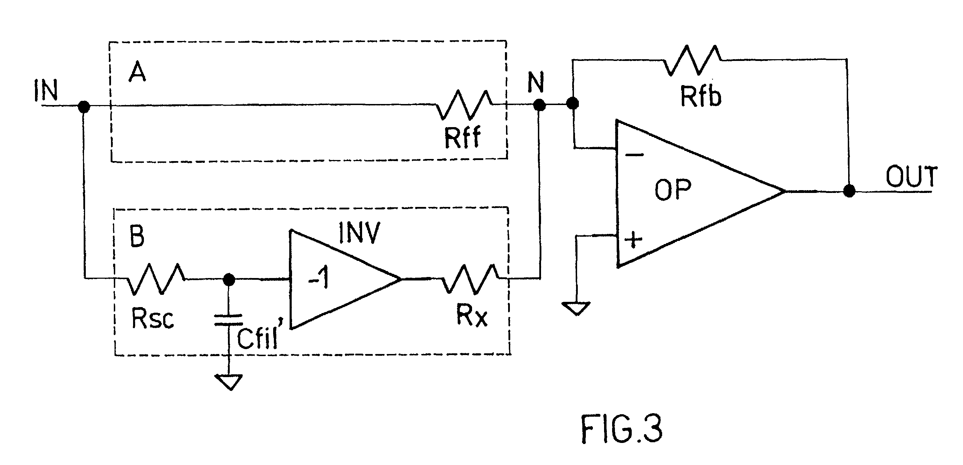

Figure 3 shows a practical embodiment of the block diagram of Figure 2. The transfer means are constituted by a resistor Rff and the low-pass filter is constituted by a filter cell formed by a series resistor Rsc and by a capacitor Cfil' in a by-pass towards the earth terminal, by an inverter INV connected to the connection point between the resistor Rsc and the capacitor Cxfil', which is the output of the cell, and by a second resistor Rx in series with the output of the inverter INV. The adder is constituted by an operational amplifier OP having its non-inverting input connected to a common reference terminal, in this case the earth terminal, and its inverting input connected to the circuit node N which connects the two resistors Rff and Rx. The two resistors Rff and Rx have substantially the same resistance and the operational amplifier is provided with feedback by means of a resistor Rfb between its output and its inverting input.

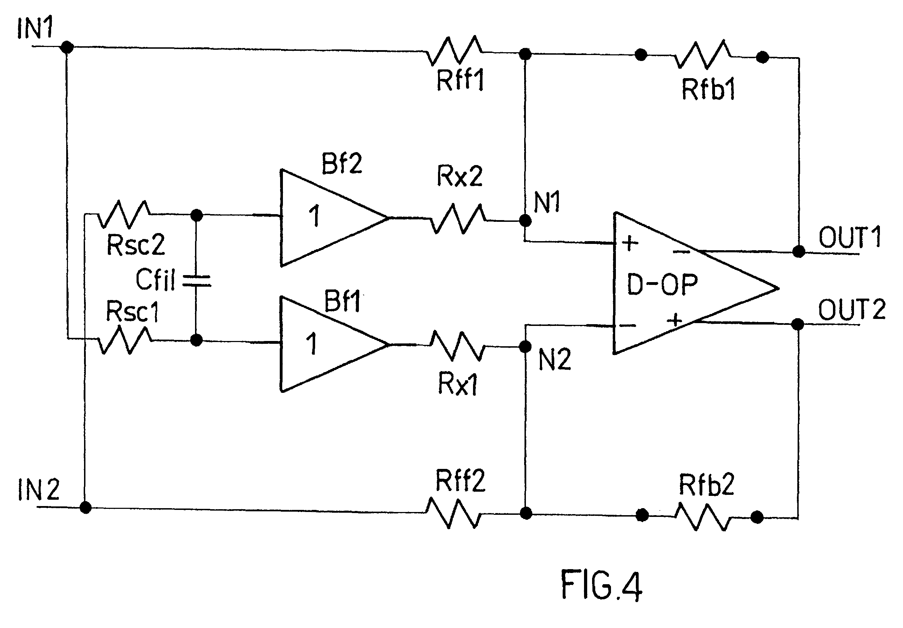

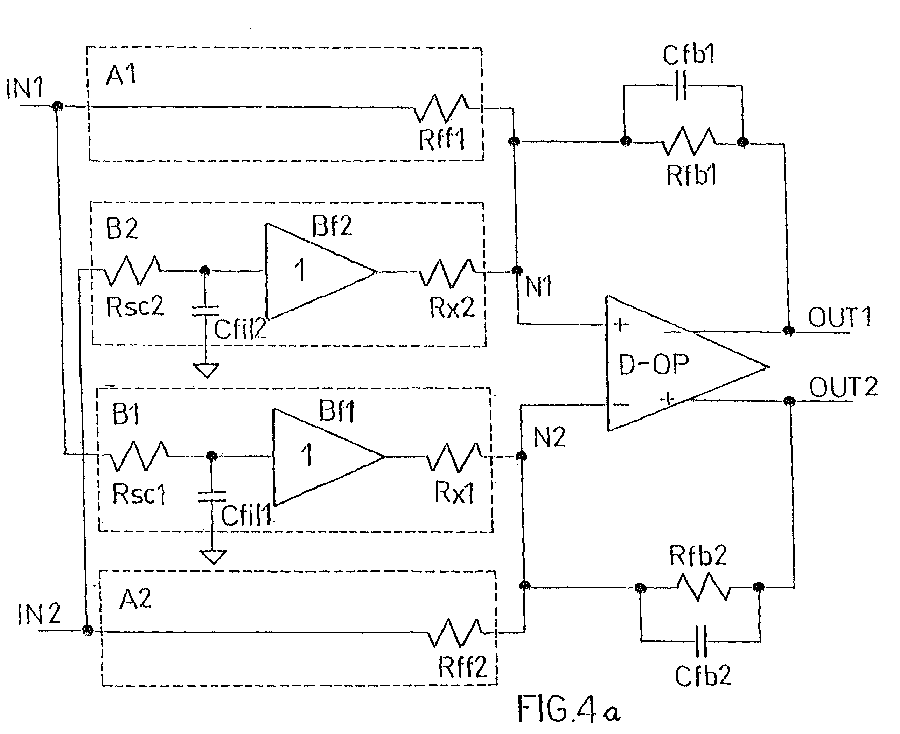

Figure 4 shows a differential version of the filter according to Figure 2. It consists of two circuit units, each with first and second-branches of which the components which are similar to those of the filter of Figure 3 are identified by means of the suffixes 1 and 2, respectively, and of an adder constituted by a differential operational amplifier, indicated D-OP. Unlike the filter of Figure 3, there is a separator (a buffer Bf1, Bf2 in each of the two second branches, instead of the inverter and, instead of each filter cell having its own capacitor connected to a reference terminal, which would also be possible, the filter cells have a common capacitor, indicated Cfil, connected between the outputs of the cells, that is, between the terminals connected to the buffers Bf1, Bf2, respectively, of the resistors Rsc1 and Rsc2. These resistors form parts of the second branches of the first and second circuit units, respectively. The other terminal of each of the two resistors Rsc1 and Rsc2 is connected, together with a terminal of one of two resistors Rff1 and Rff2 of the first branch of the respective unit, to the differential input terminals IN1 and IN2 of the filter. The output of the first branch of the first unit, that is, the other terminal of the resistor Rff1 and the output of the second branch of the second unit, that is, a terminal of the resistor Rx2, are joined together at a first circuit node, indicated N1, which is connected to the non-inverting terminal of the operational amplifier D-OP. The output of the first branch of the second unit, that is, the other terminal of the resistor Rff2, and the output of the second branch of the first unit, that is, a terminal of the resistor Rx1, are joined together at a second circuit node, indicated N2, which is connected to the inverting terminal of the amplifier D-OP. As a result of this cross-over connection, the signals which arrive at the first node N1, like those which arrive at the second node N2, always have opposite signs so that the same subtraction result is achieved as was obtained by the circuit of Figure 3 including the inverter INV.

The differential operational amplifier has two feedback resistors Rfb1 and Rfb2, connected between the respective input and output terminals. The values of the resistors Rfb1 and Rfb2 are preferably selected so that, taking account of the input resistance values, the amplifier has a gain of 1. Clearly, however, the operation of the filter shown in Figure 4 does not change if the gain is other than 1.

The transfer function of the filter of Figure 4 is:

$$H(\omega) = \frac{Vo}{Vi} = \frac{Rfb}{Rff} \; \frac{1 - \dfrac{Rff}{Rx} + j\omega Rsc2Cfil}{1 + j\omega Rsc2Cfil} \qquad (1)$$

in which Vi and Vo are the differential input and output voltages, respectively, Cfil is the capacitance of the capacitor indicated by the same symbol in Figure 4, and Rff, Rfb, Rx and Rsc are the resistances of the resistors indicated by the same symbols, with the addition of a suffix 1 or 2 in Figure 4.

If Rff is equal to Rx, that is, if equal values are selected for the resistors Rff1, Rff2, Rx1 and Rx2, the transfer function becomes:

$$H(\omega) = \frac{Rfb}{Rff} \; \frac{j\omega Rsc2Cfil}{1 + j\omega Rsc2Cfil} = \frac{Rfb}{Rff} \; \frac{j\omega}{\dfrac{1}{Rsc2Cfil} + j\omega}$$

from which it can be seen that the filter has a single pole:

$$\omega p = \frac{1}{Rsc2Cfil}$$

that is, it has a pole at the same frequency as the pole of the transfer function of the known filter of Figure 1, if Rsc = Rf and Cfil = Cf/2, and a single zero at zero frequency, like the known filter.

It should be pointed out that, if the resistances Rff and Rx are not equal, the filter has a zero for a frequency other than zero, as can easily be seen by looking at equation (1). This means that a direct-current component at the input of the filter is not cancelled out. In practice, however, it is possible to produce resistances Rff and Rx with a variation of less than 1%, which results in a wholly negligible deviation from the theoretical case. In a practical embodiment of a filter with a cancelling efficiency of 40dB connected for cancelling out the offset in a chain in which the offset of the amplifier stages upstream of the filter was about 400 mV, there was a residual offset of about 4 mV.

Another aspect to be evaluated is that of the offset introduced by the filter itself. This offset is due partly to the buffers Bf1 and Bf2 and partly to the operational amplifier D-OP of the adder. In the practical embodiment mentioned above, in which the overall gain of the filter was equal to 1 (that is, with Rx = Rff = Rfb), it has been found that the total offset was 3-4 mV, that is, little greater than that introduced by the known filter of Figure 1. The sum of the offset due to the filter and of the residual offset was between 5 and 6 mV, that is, not much greater than the offset of the filter itself.

It can be seen from the foregoing that the total offset introduced by the known filter according to Figure 4 is about twice that of the known filter according to Figure 1. However, the value involved is very low and is certainly acceptable in most practical applications, in any case involving a slight worsening of the performance for which the benefits due to the saving in area when the filter is formed in an integrated circuit are ample compensation. This saving is due to the fact that the filter according to Figure 4 requires a single capacitor, as against the four of the filter shown in Figure 1.

The advantages of the known filter according to Figure 4 in comparison with the known filter according to Figure 1 can be evaluated in two ways: by considering the same value for the resistors Rf (Figure 1) and Rsc1, Rsc2 (Figure 4), or by assigning the same total capacitance (4Cf = Cfil). to both of the filters.

In the first case (Rf = Rsc), for the same value of the pole, and assuming unitary gain in the pass band, the filter of Figure 1 requires an overall capacitance eight times larger than that required by the filter of Figure 4. The latter, however, requires six more resistors (Rffl, Rff2, Rx1, Rx2, Rfb1 and Rfb2), but the area required by these resistors is much less than that saved by virtue of the lower overall capacitance. It was clear from a comparison between the two practical circuits that the area taken up by the filter of Figure 4 was less than a quarter of that of the filter of Figure 1.

In the second case (4Cf = Cfil), for the same value of the pole, that is:

$$\omega = \frac{1}{RfCf} = \frac{1}{Rsc2Cfil}$$

Rf should equal 8Rsc.

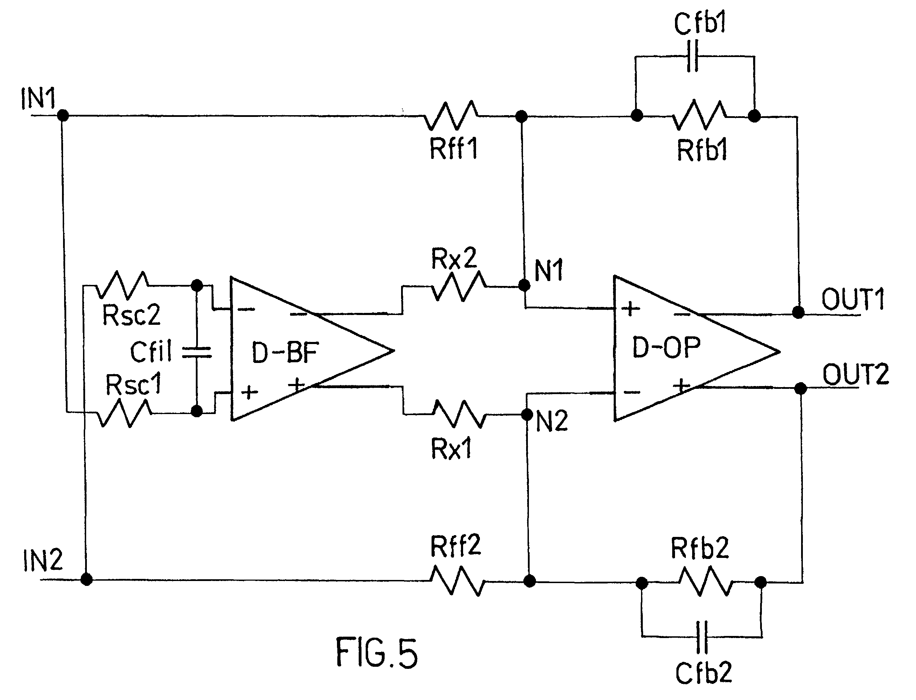

Both of these resistors have a high value and, in order to form them in the smallest possible area, they have to be formed by the switched capacitor technique. It can be shown that, to achieve the equivalent resistances necessary in the two cases by this technique, the clock frequency for the switching of the switched capacitors in the filter of Figure 1 has to be eight times lower than that necessary for the filter of Figure 4. This raises the problem of area again. In fact, with the circuit of Figure 1, in order to eliminate the clock frequency, a direct-current filter with a cut-off frequency eight times lower than that necessary for the circuit of Figure 4, and thus a time constant and hence an area for the respective capacitors eight, times larger is required. In this connection, it is interesting to note that with the circuit according to the invention, a separate filter (in practice another operational amplifier) for carrying out this function can be omitted. As shown in Figure 4a, where the same reference numerals as in Figure 4 are used to indicate similar components, a capacitor Cfb1,Cfb2 with a small capacitance is connected in parallel with each of the feedback resistors Rfb1 and Rfb2. These capacitors introduce a further pole and enable the clock frequency to be filtered out. In Figure 4a each of the two second branches (B1, B2) of the two circuit units comprises a filter cell having its own capacitor (Cfil1, Cfil2) connected to a reference (earth) terminal, instead of a common capacitor as in Figure 4. A variant of the filter according to the invention is shown in Figure 5. In this drawing, a single differential buffer circuit D-BF is provided instead of the two separate buffers Bf1 and Bf2 as a variation in comparison with the circuit of Figure 4a.

It is important to point out that, by virtue of the smaller area required by the filter according to the invention, more than one filter can be inserted in an amplifier constituted by a chain of amplifier stages, thus achieving still a saving of area and also a smaller overall offset of the chain with clear advantages as regards the dynamics and linearity of the amplifier as a whole.

**Claims**

1. A high-pass filter, with differential input and output, comprising first and second circuit units, in which each circuit unit is consituted by a first branch (A1, A2) and a second branch (B1, B2) both connected, on one side, to an input (IN1, IN2) of the high-pass filter and, on the other side, to an input (+,-) of an adder (D-OP) having a differential output which is the differential output (OUT1, OUT2) of the high-pass filter, the first branch (A1, A2) comprising means (Rff1, Rff2) for transferring an input signal substantially without modifying its frequency content, and the second branch (B1, B2) comprising a low pass- filter (Rsc1, Rsc2, Cfil1, Cfil2), the transfer means, the low-pass filter and the adder being of dimension such that the components of the input signal with frequencies below the cut-off frequency of the low-pass filter are substantially cancelled out at the output of the adder, in which the transfer means of the first branch (A1, A2) of each unit comprises a first series resistor (Rff1, Rff2), and the low-pass filter of the second branch (B1, B2) of each unit comprises a low-pass filter cell (Rsc1, Rsc2, Cfil1, Cfil2), a buffer stage (Bf1, Bf2) connected to the output of the low-pass filter cell, and a second resistor (Rx1, Rx2) connected in series with the output of the buffer, the first (Rff1, Rff2) and second resistors (Rx1, Rx2) of each unit having substantially the same resistance, in which the adder comprises a differential operational amplifier (D-OP) with its non-inverting input connected to a first circuit node (N1) to which the output of the first branch (A1) of the first unit and the output of the second branch (B2) of the second unit are connected, and with its inverting input connected to a second circuit node (N2) to which the output of the first branch (A2) of the second unit and the output of the second branch (B2) of the first unit are connected, **characterized in that** the differential operational amplifier (D-OP) has two feedback circuits each comprising a resistor (Rfb1, Rfb2) and a capacitor (Cfb1, Cfb2) in parallel.

2. A high-pass filter according to claim 1, in which the buffer stages (Bf1, Bf2) of the two circuit units are replaced by a single differential buffer circuit (D-BF).

3. A high-pass filter according to Claim 1, in which each low-pass filter cell comprises a series resistor (Rsc1, Rsc2) and a by-pass capacitor (Cfil1, Cfil2).

4. An amplifier constituted by a chain of amplifier stages in cascade and at least one high-pass filter according to any one of the preceding claims connected in the chain.


**Patentansprüche**

1. Ein Hochpaßfilter mit einem Differenzeingang und einem Differenzausgang, das eine erste und eine zweite Schaltungseinheit umfaßt, wobei jede Schaltungseinheit aus einem ersten Zweig (A1, A2) und einem zweiten Zweig (B1, B2) besteht, die beide an einer Seite mit einem Eingang (IN1, IN2) des Hochpaßfilters verbunden sind, und an der anderen Seite mit einem Eingang (+, -) eines Addierers (D-OP) mit einem Differenzausgang, der der Differenzausgang (OUT1, OUT2) des Hochpaßfilters ist, wobei der erste Zweig (A1, A2) eine Einrichtung (Rff1, Rff2) zum Übertragen eines Eingangssignals, im wesentlichen ohne Modifizieren seines Frequenzinhalts, umfaßt, und der zweite Zweig (B1, B2) ein Tiefpaßfilter (Rsc1, Rsc2, Cfill, Cfil2) umfaßt, wobei die Übertragungseinrichtung, das Tiefpaßfilter und der Addierer so dimensioniert sind, daß die Komponenten des Eingangssignals mit Frequenzen unterhalb der Grenzfrequenz des Tiefpaßfilters an dem Ausgang des Addierers im wesentlichen ausgelöscht werden, wobei die Übertragungseinrichtung des ersten Zweigs (A1, A2) jeder Einheit einen ersten Reihenwiderstand (Rff1, Rff2) umfaßt, und das Tiefpaßfilter des zweiten Zweigs (B1, B2) jeder Einheit eine Tiefpaßfilterzelle (Rsc1, Rsc2, Cfill, Cfil2), eine Pufferstufe (Bf1, Bf2), die mit dem Ausgang der Tiefpaßfilterzelle verbunden ist, und einen zweiten Widerstand (Rx1, Rx2) umfaßt, der in Reihe mit dem Ausgang des Puffers geschaltet ist, wobei der erste (Rff1, Rff2) und der zweite Widerstand (Rx1, Rx2) jeder Einheit im wesentlichen den gleichen Widerstandswert aufweisen, wobei der Addierer einen Differenzoperationsverstärker (D-OP) umfaßt, der nicht-invertierende Eingang desselben mit einem ersten Schaltungsknoten (N1) verbunden ist, mit dem der Ausgang des ersten Zweigs (A1) der ersten Einheit und der Ausgang des zweiten Zweigs (B2) der zweiten Einheit verbunden sind, und der invertierte Eingang desselben mit einem zweiten Schaltungsknoten (N2) verbunden ist, mit dem der Ausgang des ersten Zweigs (A2) der zweiten Einheit und der Ausgang des zweiten Zweigs (B2) der ersten Einheit verbunden sind, **dadurch gekennzeichnet, daß** der Differenzoperationsverstärker (D-OP) zwei Rückkopplungsschaltungen aufweist, die jeweils einen Widerstand (Rfb1, Rfb2) und einen Kondensator (Cfb1, Cfb2) parallel umfassen.

2. Ein Hochpaßfilter gemäß Anspruch 1, bei dem die Pufferstufen (Bf1, Bf2) der beiden Schaltungseinheiten durch eine einzige Differenzpufferschaltung (D-BF) ersetzt sind.

3. Ein Hochpaßfilter gemäß Anspruch 1, bei dem jede Tiefpaßfilterzelle einen Reihenwiderstand (Rsc1, Rsc2) und einen Umgehungskondensator (Cfill, Cfil2) umfaßt.

4. Ein Verstärker, der durch eine Kette von Verstärkerstufen in Kaskade aufgebaut ist, und zumindest ein Hochpaßfilter gemäß einem der vorhergehenden Ansprüche, das in der Kette verschaltet ist.


**Revendications**

1. Filtre passe-haut ayant une entrée et une sortie différentielles comprenant des première et seconde unités de circuits, dans lequel chaque unité de circuit est constituée d'une première branche (A1, A2) et d'une seconde branche (B1, B2) toutes deux connectées, d'un côté, à une entrée (IN1, IN2) du filtre passe-haut et, de l'autre côté, à une entrée (+, -) d'un additionneur (D-OP) ayant une sortie différentielle qui est la sortie différentielle (OUT1, OUT2) du filtre passe-haut, la première branche (A1, A2) comprenant un moyen (Rff1, Rff2) pour transférer un signal d'entrée sensiblement sans en modifier le contenu en fréquence, et la seconde branche (B1, B2) comprenant un filtre passe-bas (Rsc1, Rsc2, Cfil1, Cfil2), le moyen de transfert, le filtre passe-bas et l'additionneur étant dimensionnés de façon que les composantes du signal d'entrée qui ont des fréquences inférieures à la fréquence de coupure du filtre passe-bas soient sensiblement éliminées à la sortie de l'additionneur, dans lequel le moyen de transfert de la première branche (A1, A2) de chaque unité comprend une première résistance série (Rff1, Rff2), et le filtre passe-bas de la seconde branche (B1, B2) de chaque unité comprend une cellule de filtre passe-bas (Rsc1, Rsc2, Cfil1, Cfil2), un étage tampon (Bfl, Bf2) connecté à la sortie de la cellule de filtre passe-bas, et une seconde résistance (Rxl, Rx2) connectée en série à la sortie du tampon, les première (Rff1, Rff2) et seconde résistances (Rxl, Rx2) de chaque unité ayant sensiblement la même résistance, dans lequel l'additionneur comprend un amplificateur opérationnel (D-OP) dont l'entrée non inverseuse est connectée à un premier noeud de circuit (N1) auquel sont connectées la sortie de la première branche (A1) de la première unité et la sortie de la seconde branche (B2) de la seconde unité, et dont l'entrée inverseuse est connectée à un second noeud de circuit (N2) auquel sont connectées la sortie de la première branche (A2) de la seconde unité et la sortie de la seconde branche (B2) de la première unité, **caractérisé en ce que** l'amplificateur opérationnel différentiel (D-OP) a deux circuits de contre-réaction comprenant chacun une résistance (Rfbl, Rfb2) et un condensateur (Cfbl, Cfb2) en parallèle.

2. Filtre passe-haut selon la revendication 1, dans lequel les étages tampons (Bfl, Bf2) de deux unités de circuit sont remplacés par un circuit tampon différentiel unique (D-BF).

3. Filtre passe-haut selon la revendication 1, dans lequel chaque cellule de filtre passe-bas comprend une résistance série (Rsc1, Rsc2) et un condensateur de dérivation (Cfill, Cfi12).

4. Amplificateur constitué par une chaîne d'étages amplificateurs en cascade et au moins un filtre passe-haut selon l'une quelconque des revendications précédentes, connectés dans la chaîne.

FIG.1

FIG.2

FIG.3

FIG.4

FIG.4a

FIG.5